# EUROPÄISCHE PATENTSCHRIFT

(11) **EP 1 440 475 B1**
(45) Veröffentlichungstag und Bekanntmachung des Hinweises auf die Patenterteilung: **21.05.2008**
(21) Anmeldenummer: 02779167.2
(22) Anmeldetag: 18.10.2002
(51) Int. Cl.: H01L 31/00, H01L 31/115

(54) **TRANSMISSIONSDETEKTOR NEBST HERSTELLUNGSVERFAHREN**
TRANSMISSION DETECTOR AND A CORRESPONDING PRODUCTION METHOD
DETECTEUR DE TRANSMISSION ET PROCEDE DE FABRICATION

(30) Priorität: 31.10.2001 DE 10153241
(43) Veröffentlichungstag der Anmeldung: 28.07.2004
(73) Patentinhaber: Forschungszentrum Jülich GmbH, 52425 Jülich (DE)
(72) Erfinder: PROTIC, Davor, 52428 Jülich (DE); KRINGS, Thomas, 52441 Linnich (DE)
(86) Internationale Anmeldenummer: PCT/DE2002/003942
(87) Internationale Veröffentlichungsnummer: WO 2003/038472

(56) Entgegenhaltungen:
- US-A- 3 225 198
- US-A- 3 413 528
- US-A- 3 413 529
- LIATARD E ET AL: "DETECTION DE PRODUCTS DE FISSION A L'AIDE DE CELLULES PHOTOVOLTAIQUES" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. A267, Nr. 1, 15. April 1988 (1988-04-15), Seiten 231-234, XP000119282 ISSN: 0168-9002
- HOROWITZ Y S ET AL: "A beta-ray spectrometer based on a two-or three silicon detector coincidence telescope" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. A371, Nr. 3, 11. März 1996 (1996-03-11), Seiten 522-534, XP004010103 ISSN: 0168-9002

## Beschreibung

Die Erfindung betrifft ein Verfahren für die Herstellung eines Detektors für die Energiebestimmung von Photonen und geladenen Teilchen und zwar einen sogenannten ΔE- oder Transmissionsdetektor. Die Erfindung betrifft einen verfahrensgemäß herstellbaren Detektor.

Transmissions- oder ΔE-Detektoren aus hochreinem Silizium sind kommerziell erhältlich und zwar bis zu einer Dicke von 1 mm. Gelegentlich werden auch bis zu 2 mm dicke ΔE-Detektoren angeboten, die aus hochreinem Silizium bestehen.

Sollen ΔE-Detektoren mit größeren Dicken von 2-10 mm bereitgestellt werden, so kann reines Silizium nicht mehr eingesetzt werden, da das Material nicht mit dem erforderlichen Reinheitsgrad bereitgestellt werden kann. Daher wird dann als Basismaterial mit Lithium kompensiertes Silizium [Si(Li)] eingesetzt. Derartige kommerziell erhältliche Si(Li)-Detektoren weisen einen p⁺-kontakt auf, der kleiner als 1 µm dick ist. Es handelt sich um eine Oberflächensperrschicht, die durch Bor-Implantation oder Bedampfen mit einer Metallschicht und zwar insbesondere durch Bedampfen mit Gold hergestellt worden sein kann. Ferner weisen diese Si(Li)-Detektoren einen 100-500 µm dicken Li-diffundierten n-Kontakt auf.

Innerhalb der dieser 100-500 µm dicken n-Kontakt-Schicht verliert ein geladenes Teilchen oder Photon seine Energie, ohne dass der Detektor darauf reagiert. Der Bereich der Schicht, in dem der Detektor nicht auf den Energieverlust des geladenen Teilchens reagiert, wird nachfolgend "tote Zone" genannt. Die tote Zone trägt also nicht zur Energiebestimmung von Photonen oder geladenen Teilchen bei.

In den Druckschriften IEEE Trans. Nucl. Sci. NS-25, No 1 (1978) 391; IEEE Trans. Nucl. Sci. NS-31, No 1 (1984) 331; IEEE Trans. Nucl. Sci. NS-43, No 3 (1996) 1505 sind Verfahren angegeben, um die Dicke des Li-diffundierten Kontaktes auf 10-20 µm zu reduzieren. Es verbleibt jedoch eine 10-20 µm und damit immer noch relativ dicke unempfindliche, also tote Zone des Si(Li)-Detektors. Eine solche tote Zone wirkt sich in der Praxis nach wie vor merklich nachteilhaft bei einem Transmissionsdetektor aus.

Das Dokument US 3,413,528 beschreibt einen Si(Li)-Detektor und ein Herstellungsverfahren mit Diffusion von Lithium.

Einige Autoren haben über ΔE-Detektoren aus Li-kompensiertem Silizium, bei denen der Li-diffundierte n-Kontakt ganz entfernt wurde, berichtet. Anstelle des n-Kontaktes wurde ein ohmscher Kontakt durch Aufdampfen einer Aluminiumschicht erzeugt, wie der Druckschrift Jpn. J. Appl. Phys. 33 (1994) 4115 zu entnehmen ist.

Diese Si(Li)-Detektoren, also aus Li-kompensiertem Silizium hergestellte Detektoren, mögen eine Zeitlang nach der Herstellung gut funktionieren. Aber dieselben Autoren berichteten über ernsthafte Probleme mit der Langzeitstabilität solcher Detektoren mit ohmschen Kontakten, wie den Druckschriften Jpn. J. Appl. Phys. 33 (1994) 4111 sowie Jpn. J. Appl. Phys. 34 (1995) 3065 zu entnehmen ist.

Es ist aus der Druckschrift G. F. Knoll, "Radiation Detection and Measurement", Chapter 13, John Wiley & Sons, New York, 2000 bekannt, dass die Si(Li)-Detektoren bei Raumtemperatur ihre Eigenschaften einige Zeit und zwar in der Regel einige Monate nach der Herstellung behalten. Dann aber findet eine Redistribution des Lithiums innerhalb des kompensierten Volumens statt. Einige Lithium-Ionen, die an die Akzeptor-Ionen gebunden waren, wandern zu den Kristalldefekten oder anderen Verunreinigungen. Das kompensierte Silizium wandelt sich zum p-Typ. Zur Verminderung des Problems wird von den Herstellern empfohlen, bei Raumtemperatur immer eine Sperrspannung an die Detektoren anzulegen, wenn diese nicht in Betrieb sind. Damit können die Kompensationaverluste durch "Nachdriften" ausgeglichen werden.

Eine solche Behandlung ist bei den Transmissionsdetektoren, die ohne Li-diffundierten Kontakt hergestellt sind, nicht durchführbar, da eine p-Schicht unterhalb des ohmschen Kontaktes wieder entstehen würde. Hieraus ergeben sich Langzeitstabilitätsprobleme.

Si(Li)-Detektoren können durch die Strahlen im Laufe der Messungen geschädigt werden. Solche geschädigten Si(Li)-Detektoren werden durch das sogenannte "Redriften", d. h. Dritt bei Temperaturen zwischen 50°C und 100°C regeneriert, wie aus der Druckschrift M. Jaskola and K. Nybø, Nucl. Instr. Meth. 44 (1966) 141 bekannt ist. Dabei werden durch "Nachdriften" die durch Strahlung entstandenen Gitterdefekte (meistens p-Typ) mit Li-Ionen kompensiert. Bei den Transmissionsdetektoren ohne Li-diffundierten Kontakt ist ein solches Verfahren nicht möglich, da sich eine p-Schicht unterhalb des ohmschen Kontaktes bilden würde. Auch aus diesem Grund ergeben sich Langzeitstabilitätsprobleme.

Aufgabe der Erfindung ist die Schaffung eines Verfahren für die Herstellung eines Detektors der eingangs genannten Art, der langzeitstabil sind und bei dem tote Zonen deutlich vermindert sind. Aufgabe der Erfindung ist ferner die Bereitstellung eines solchen Detektors.

Zur Lösung der Aufgabe wird verfahrensgemäß ein Si(Li)-Bauelement bereitgestellt, welches eine p⁺- sowie eine n-Schicht aufweist. Es kann sich dabei um nach dem vorgenannten Stand der Technik hergestellte Schichten handeln. Verfahrensgemäß wird die n-Schicht zum Beispiel durch chemisches Ätzen, durch Feinschliff oder durch Läppen teilweise abgetragen. Insbesondere Läppen hat sich bewährt. Hierdurch wird die Zone reduziert, die in einem Detektor der eingangs genannten Art unwirksam ist. Aus dem so behandelten Bauelement wird der Detektor hergestellt. Im Vergleich zum nach dem jeweiligen Stand der Technik hergestellten Detektor ist die tote Zone verringert worden.

Die n-Schicht im Bauelement wird durch eingebrachte Fremdionen gebildet, also Ionen, die nicht aus Silizium bestehen. Als Fremdionen sind insbesondere Lithiumionen vorgesehen.

Das Bauelement ist bevorzugt 2 bis 10 mm dick. Die p⁺-Schicht begrenzt das Bauelement auf der einen und die n-Schicht das Bauelement auf der anderen Seite. Anstelle der p⁺-Schicht kann auch eine p⁻- oder p-Schicht vorgesehen sein. Anstelle der n-Schicht kann auch eine n⁻- oder n⁺-Schicht vorgesehen sein. Zu bevorzugen ist jedoch, dass schließlich im fertigen Detektor eine p⁺-Schicht auf der einen und eine n-Schicht auf der anderen Seite vorliegt.

In einer Ausgestaltung der Erfindung wird der Schichtwiderstand an der Oberfläche der n-Schicht während des Abtragens gemessen. Das Abtragen wird gestoppt, wenn die gemessene spezifische Leitfähigkeit einen vorgegebenen Wert erreicht, der vorzugsweise zwischen 1.000 Ω/□ und 20.000 Ω/□ liegt (□ = cm²). Insbesondere sollte 10.000 Ω/□ nicht überschritten werden. Die Leitfähigkeit ist ein Maß für die Li-Konzentration im Silizium. Es wird so erreicht, dass das Abtragen gestoppt wird, sobald Konzentrationsbereiche erreicht werden, die nicht unterschritten werden sollten. So wird vermieden, dass durch das Abtragen nicht versehentlich die n-Schicht vollständig entfernt wird.

In einer weiteren Ausgestaltung der Erfindung wird die n-Schicht hergestellt, indem Lithium mittels Diffusion in die betreffende Schicht gebracht wird. Dabei diffundiert Lithium durch die Oberfläche hindurch, die erfindungsgemäß abgeschliffen wird, um so die tote Zone zu verringern. Auf diese Weise wird erreicht, dass nach abgeschlossener Diffusion die Lithiumkonzentration mit zunehmender Tiefe - von der genannten Oberfläche aus gesehen - abnimmt. Wird abgetragen und währenddessen die jeweilige Lithiumkonzentration ermittelt und bei einem vorgegebenen Konzentrationswert gestoppt, so kann die tote Zone auf 0,5 bis 5µm, so zum Beispiel auf 1 µm reduziert werden. Je kleiner die tote Zone ist, desto geringer sind die hiermit verbundenen eingangs genannten Nachteile. Eine tote Zone von 1 µm wird in der Praxis nicht mehr als störend bemerkt.

Gestoppt wird in einer Ausführungsform der Erfindung das Abtragen, wenn die Lithiumkonzentration im Silizium zwischen 10¹⁵/cm³ und 10¹¹/cm³ angelangt ist. Es werden so Konzentrationswerte erreicht, die für die Bildung der n-Schicht hinreichend groß sind. Ein Wert ist zu bevorzugen, der in der Nähe von 10¹⁵/cm³ liegt. Auf diese Weise steht ein hinreichend großer Lithiumvorrat zur Verfügung, durch den das Funktionieren des Detektors mehrere Jahre lang sichergestellt werden kann. Wird abgetragen, bis die Lithiumkonzentration bei 10¹¹/cm³ erreicht ist, so steht schließlich zwar ein funktionstüchtiger Detektor zur Verfügung. Innerhalb von relativ kurzer Zeit würde die Konzentration jedoch soweit absinken, dass der Detektor nicht mehr funktioniert.

Ist Lithium durch Diffusion in das Silizium zur Herstellung der n-Schicht eingebracht worden und wird das Abtragen bei Erreichen eines (elektrischen) Schichtwiderstands von 5000 Ω/□ gestoppt, so entspricht dies regelmäßig einer Lithiumkonzentration von 10¹² Li-Ionen pro cm² n-Schicht. Die Lithiumkonzentration an der Oberfläche beträgt dann typischerweise 10¹⁴ bis 5*10¹⁴ cm⁻³.

Um zu einem besonders geeigneten Verlauf der Lithiumkonzentration zu gelangen, wird die Diffusion des Lithiums bei Temperaturen von 200 bis 250 °C durchgeführt. Nach dem verfahrensgemäßen Abtragen wird vorteilhaft so ein Konzentrationsgradient dN/dx der Lithiumionen im Silizium erhalten, der um ein bis zwei Größenordnungen geringer im Vergleich zum Stand der Technik ist, der aus der Druckschrift IEEE Trans. NS-31, No.1 (1984) 331 bekannt ist. Das Dickenwachstum des Kontakts ist damit wesentlich reduziert.

Die Aufgabe der Erfindung wird also besonders gut durch eine dünne durch Li-Diffusion erzeugte n-Schicht (Kontakt) gelöst. Die effektive Dicke beträgt weniger als 1 µm Silizium. Folgende Schritte sind für die Herstellung der besten Ausführungsform wesentlich:
1. Li-Diffusion bei relativ tiefer Temperatur -200-250°C.
2. Entfernen der Oberflächenschicht, je nach dem Verlauf der Li-Konzentration in der Li-diffundierten Schicht werden typischerweise 20 bis 50 µm abgetragen.

In einer weiteren Ausführungsform der Erfindung wird eine Aluminiumschicht als Verbindung zum Li-diffundierten Kontakt abschließend aufgedampft.

Die gesamte Anzahl der Lithium-Ionen in dem Kontakt ist noch immer ausreichend, um den Detektor jahrelang unter Arbeitsspannung auf Zimmertemperatur betreiben zu können oder ein Nachdriften nach Strahlenschäden durchzuführen.

Die kleine effektive Dicke des Kontaktes steht in Verbindung mit der relativ kleinen Li-Konzentration in dem Kontakt. Deswegen kann das elektrische Feld teilweise in den Kontakt eindringen. Die in dem Kontakt erzeugten Elektronen-Loch-Paare (beim Durchgang eines geladenen Teilchens oder Abstoppen eines Photons) haben aufgrund der niedrigen Li-Konzentration größere Diffusionslängen, d.h. ein Teil davon wird noch während der Signalverarbeitungszeit durch das Feld gesammelt. Dieser Prozess wird noch durch das interne Feld, verursacht durch den Konzentrationsgradienten, begünstigt. Auf diese Weise kann man die kleine effektive Dicke des Kontaktes erklären.

Ein weiterer Vorteil des dünnen Li-diffundierten Kontaktes liegt in der Möglichkeit der Strukturierung, so dass auch beidseitig digital-ortsempfindliche Transmissionsdetektoren aus lithiumkompensiertem Silizium hergestellt werden können.

### Ausführungsbeispiel:

Zuerst wird ein Si(Li)-Detektor nach allgemein bekanntem Verfahren hergestellt ("normale" Li-Diffusion in das p-Typ Silizium, Kompensation durch Li-Drift bis zum p⁺-Kontakt, der durch Bor-Implantation oder Gold-Bedampfung erzeugt wird). Dann wird der Li-diffundierte Kontakt vollständig abgetragen.

Eine neue Li-Diffusion wird durchgeführt. Hierfür wird LiAlH₄-Pulver in Äther gelöst. Auf das Siliziumsubstrat, welches an einer Seite bereits den p⁺-Kontakt aufweist, wird auf der entgegengesetzten Seite das gelöste Pulver aufgebracht. Hierauf wird eine Glasplatte gelegt und der Aufbau in einen Diffusionsofen gebracht. Im Ofen wird eine Inertgasatmosphäre erzeugt. Argon oder Stickstoff sind geeignete Gase für die Erzeugung der Inertgasatmosphäre. Die Temperatur im Ofen wird langsam aufgeheizt und zwar auf eine Temperatur zwischen 200 und 250°C. 30 Minuten lang wird die Temperatur aufrechterhalten. Das gelöste Pulver zersetzt sich und der Wasserstoff entweicht. Lithium diffundiert dann in das Siliziumsubstrat. Anschließend wir der Aufbau aus dem Ofen entfernt und die Glasplatte abgenommen. Zunächst wird durch Läppen die restliche, verbliebene Aluminium-Lithium-Mischung entfernt. Hierunter ist zu verstehen, dass mittels Pulver Material sozusagen abgeschmirgelt wird.

Durch Läppen wird Material weiter abgetragen, bis der Schichtwiderstand an der Oberfläche 5000 Ω/□ beträgt. Der Gradient der Lithiumkonzentration liegt dann typischerweise zwischen 10¹⁵ cm⁻³/10 µm bis 10¹⁵cm⁻³/20 µm (Mittelwert).

Die Oberfläche wird schließlich chemisch poliert und mit einer aufgedampften Aluminiumschicht versehen.

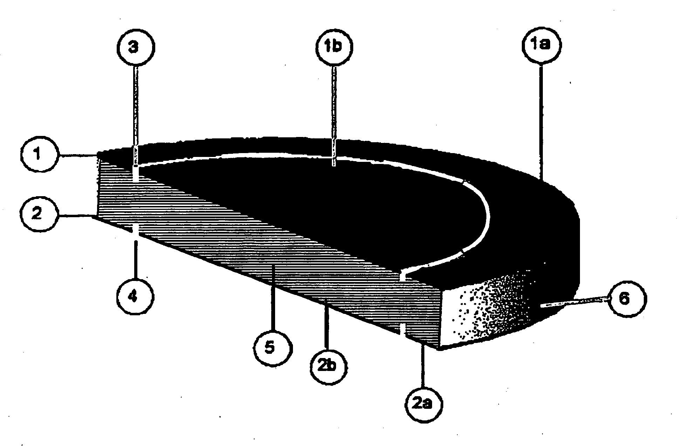

Der so hergestellte in der Figur gezeigte n-Kontakt (1) bekommt durch einen plasmageätzten Graben (3) einen Guard-Ring (1a), über den der störende Stromanteil des Detektors, verursacht durch die Außenfläche des kompensierten Siliziums (6), fließt. Das empfindliche Volumen des Detektors ist durch den inneren n-Kontakt (1b), das Li-kompensierte Silizium (5) und den p⁺-Kontakt (2), der auch durch einen Graben (4) in den inneren Kontakt (2b) und einen Guard-Ring (2a) geteilt werden kann, bestimmt.

Die Bestimmung des Schichtwiderstandes erfolgte durch die sogenannte 4-Spitzenmethode. Vier metallische Spitzen werden auf die betreffende Oberfläche gedrückt und darüber der gesuchte Widerstand ermittelt.

### Bezugzeichenliste

- 1: n-Kontakt (Lithium-Diffusion)
- 1a: Guard-Ring des Lithium-diffundierten Kontaktes
- 1b: innerer n-Kontakt
- 2: p⁺-Kontakt (Bor-Implantation)
- 2a: Guard-Ring des p⁺-Kontaktes
- 2b: innerer p⁺-Kontakt
- 3: Graben (in diesem Fall: ∼50 µm breit, ∼30 µm tief)
- 4: Graben (in diesem Fall: ∼30 µm breit, ∼10 µm tief)
- 5: Lithiumkompensiertes Silizium
- 6: Außenfläche des kompensierten Siliziums

## Patentansprüche

1. Verfahren für die Herstellung eines Detektors für die Energiebestimmung von Photonen oder geladenen Teilchen mit den Schritten:
- Bereitstellen eines im wesentlichen aus Silizium bestehendes Bauelements,
- Einbringen von Lithium durch Diffusion in eine n-, n⁻- oder n⁺-Schicht des Bauelements,
- Abtragen eines Teils dieser Schicht,
- Verarbeitung des Bauelements derart, dass hieraus der Detektor entsteht,
**dadurch gekennzeichnet, dass**
der Schichtwiderstand an der Oberfläche der n-, n⁻- oder n⁺-Schicht während des Abtragens ermittelt und das Abtragen gestoppt wird, wenn der gemessene Schichtwiderstand einen vorgegebenen Wert erreicht, der zwischen 1.000 und 20.000 Ω/□ liegt, wobei
die n-, n⁻- oder n⁺-Schicht soweit abgetragen wird, bis so eine tote Zone bereitgestellt werden kann, die 0,5 bis 5 µm dick ist.

2. Verfahren nach Anspruch 1, bei der Teil der n-, n⁻- oder n⁺-Schicht durch chemisches Ätzen oder durch Läppen abgetragen wird und zwar insbesondere 20 bis 50 µm.

3. Verfahren nach einem der vorhergehenden Ansprüche, bei dem das bereitgestellte Bauelement 2 bis 10 mm dick ist und/ oder durch eine p⁺-Schicht auf der einen und der n-Schicht auf der anderen Seite begrenzt wird und/ oder mit Lithium kompensiert ist.

4. Verfahren nach einem der vorhergehenden Ansprüche, bei dem die n-, n⁻- oder n⁺-Schicht bereitgestellt wird, indem Lithium mittels Diffusion in die betreffende Schicht gebracht wird, wobei die Diffusion bevorzugt bei Temperaturen zwischen 200 und 250°C durchgeführt wird und zwar insbesondere in einer Inertgasatmosphäre.

5. Verfahren nach einem der vorhergehenden Ansprüche, bei dem die n-, n⁻- oder n⁺-Schicht soweit abgetragen wird, bis die Konzentration der Ionen, durch die n-, n⁻- oder n⁺-Schicht im Siliziumsubstrat bereitgestellt wird, zwischen 10¹⁵g/cm³ und 10¹¹/cm³ angelangt ist.

## Claims

1. Process for producing a detector for determining the energy of photons or charged particles and having the following stages:
- the preparation of a component element made essentially from silicon,
- the introduction of lithium into an n, n⁻ or n⁺ layer of the component blank by diffusion,
- the removal of part of this layer,
- machining of the component, giving rise to a detector,
**characterized in that**
the film resistance on the surface of the n, n⁻ or n⁺ layer is recorded and the removal of material is stopped when the measured film resistance reaches a set value of between 1,000 and 20,000 Ω/□,
whereby the n, n⁻ or n⁺ layer is removed until a dead layer of from 0.5 to 5.0 µm can be produced.

2. Process in accordance with claim 1, in which part of the n, n⁻ or n⁺ layer is removed, particularly 20 to 50 µm, by chemical etching or by lapping.

3. Process, in accordance with one of the above claims, in which the component produced is 2 to 10 mm thick and/or is bordered by a p⁺-layer on one side and by an n-layer on the other side and/or is compensated with lithium.

4. Process, in accordance with one of the above claims, in which the n, n⁻ or n⁺ layer is produced by diffusing lithium into the relevant layer, whereby the diffusion is preferably carried out at temperatures of between 200 and 250°C, and particularly in an inert gaseous environment.

5. Process, in accordance with one of the above claims, in which the n, n⁻ or n⁺ layer is removed until the ion concentration through the n, n⁻ or n⁺ layer in the silicon substrate is between 10¹⁵/cm³ and 10¹¹/cm³.

## Revendications

1. Procédé de fabrication d'un détecteur pour la détermination de l'énergie de photons ou de particules chargées comprenant les stades dans lesquels :
- on se procure un composant constitué essentiellement de silicium,
- on introduit du lithium par diffusion dans une couche n, n⁻ ou n⁺ du composant,
- on enlève une partie de cette couche,
- on traite le composant de manière à en créer le détecteur,
**caractérisé en ce que**,
on détermine la résistance de la couche à la surface de la couche n, n⁻ ou n⁺ pendant l'enlèvement et on arrête l'enlèvement lorsque la résistance de la couche qui est mesurée atteint une valeur prescrite comprise entre 1000 et 20 000 (Ω/□)
dans lequel
on enlève la couche n, n⁻ ou n⁺ jusqu'à ce qu'une zone morte d'une épaisseur de 0,5 à 5 µm puisse être préparée.

2. Procédé suivant la revendication 1, dans lequel on enlève la partie de la couche n, n⁻ ou n⁺ par attaque chimique ou par polissage et cela notamment à raison dé 20 à 50 µm.

3. Procédé suivant l'une des revendications précédentes, dans lequel le composant 2 que l'on s'est procuré a une épaisseur allant jusqu'à 10mm et/ou est limitée par une couche p⁺ sur l'une des faces et par la couche n sur l'autre face et/ou est compensée par du lithium.

4. Procédé suivant l'une des revendications précédentes, dans lequel on prépare la couche n, n⁻ ou n⁺ en mettant du lithium par diffusion dans la couche concernée, la diffusion étant effectuée de préférence à des températures comprises entre 200 et 250°C est en fait notamment dans une atmosphère de gaz inerte.

5. Procédé suivant l'une des revendications précédentes, dans lequel on enlève la couche n, n⁻ ou n⁺ jusqu'à ce que la concentration des ions par lesquels la couche n⁻ ou n⁺ est préparé dans le substrat en silicium atteigne une valeur comprise entre 10¹⁵/cm³ et 10¹¹/cm³.
